# EUROPEAN PATENT SPECIFICATION

(11) **EP 4 318 927 B1**
(45) Date of publication and mention of the grant of the patent: **18.02.2026**
(21) Application number: 22815660.0
(22) Date of filing: 24.03.2022
(51) Int. Cl.: B81B 7/00, H02N 1/00, H01G 7/02, H01G 5/011

(54) **ELECTRET DEVICE**
ELEKTRETVORRICHTUNG
DISPOSITIF À ÉLECTRET

(30) Priority: 31.05.2021 JP 2021091225; 17.03.2022 JP 2022043051
(43) Date of publication of application: 07.02.2024
(73) Proprietor: Saginomiya Seisakusho, Inc., Tokyo 165-0033 (JP)
(72) Inventor: ISHIBASHI Kazunori, Sayama-shi, Saitama 350-1395 (JP); ISHIGURO Takuma, Sayama-shi, Saitama 350-1395 (JP); MITSUYA Hiroyuki, Sayama-shi, Saitama 350-1395 (JP)
(74) Representative: Kramer Barske Schmidtchen Patentanwälte PartG mbB
(86) International application number: PCT/JP2022/014020
(87) International publication number: WO 2022/254903

(56) References cited:
- WO-A1-2006/057492
- JP-A- 2009 516 916
- JP-A- 2013 520 022
- JP-A- S5 080 683
- JP-A- S63 202 842
- US-A1- 2012 043 851
- US-A1- 2013 207 248
- US-B2- 9 190 936

## Description

### Technical Field

The present invention relates to an electret device and a method of manufacturing an electret device.

### Background Art

A method of generating power using a MEMS (Micro Electro Mechanical Systems) vibration element has been known as an energy harvesting technique to harvest an energy from environmental vibration (see PTL 1, for example).

Some vibration elements use an electret, i.e., a material obtained by, for example, applying a voltage to a dielectric so as to kept it in a charged state. Electrets are fabricated by a method involving injecting electric charge into an insulating film by corona discharge, the method disclosed in PTL 2, or the like.

Here, the amount of charge of electrets decreases with the passage of time. This is called charge degradation. It is known that the charge degradation occurs mainly due to contact between the electret and the moisture in the ambient air (see PTL 3, etc.).

Usually, electronic elements are sealed in vacuum packages in order to keep the electronic elements from degrading due to the moisture. Moreover, an adsorbent called a getter is placed in a vacuum package in order to maintain the inside of the vacuum package in the vacuum state (see Non PTL 1, etc.).

### Citation List

### Patent Literatures

PTL 1: Japanese Patent Laid-Open No. 2018-088780
PTL 2: Japanese Patent Laid-Open No. 2013-13256
PTL 3: Japanese Patent Laid-Open No. 2008-182666
PTL 4: Japanese Patent Laid-Open No. 2014-049557
PTL 5: Japanese Patent No. 4662666

US 2012/043851 A1 discloses an electret device comprising a package member, a lid member, and an electret member, wherein the lid member seals the package member to thereby form a closed space and wherein the electret element is placed in the closed space. US 2013/0207248 A1 discloses an electromechanical device comprising a hydrogen getter. US 9,190,936 B2 discloses another MEMS.

### Non Patent Literature

NPL 1: "Integration and Packaging Technologies for Small Biomedical Sensors" by Eiji Higurashi, et al., Journal of the Japan Society for Precision Engineering Vol.73, No. 11, P.1190 (2007)

### Summary of Invention

### Technical Problem

Note that the surface of the getter material for maintaining a vacuum is covered with molecules adsorbed from gases, and heating (e.g., at 400°C or higher) needs to be performed in a vacuum for activation. Such a heating treatment may reduce the electric charge of the electret.

Moreover, focusing on the fact that the charge degradation occurs in spite of moisture removal, the inventors have found that one of its causes is that hydrogen atoms H⁺ react with SiO⁻ molecules in a silicon oxide film storing electric charge therein, thereby neutralizing the electric charge, and it is necessary to take some countermeasure against this.

Thus, an object of the present invention is to provide a long-life electret device preventing charge degradation of an electret element sealed in a closed space by removing hydrogen, which can be a cause of the degradation, without performing a high-temperature treatment.

### Solution to Problem

The above object is achieved by an electret device according to claim 1 or a method according to claim 9.

Further improvements are given in the dependent claims.

### Advantageous Effect of Invention

According to the present invention, it is possible to provide an electret device capable of adsorbing hydrogen in a closed space without performing a high-temperature treatment to prevent charge degradation of an electret sealed in the closed space, and to provide a method of manufacturing the same.

### Brief Description of Drawings

[Fig. 1] Fig. 1(a) is a perspective view illustrating an electret device according to an embodiment of the present invention, Fig. 1(b) is an exploded perspective view of the electret device in Fig. 1(a), and Fig. 1(c) is a back view of a lid member 20 in Fig. 1(a); [Fig. 2] Fig. 2 is a cross-sectional view of the electret device in Fig. 1(a);
[Fig. 3] Fig. 3(a) is a perspective view illustrating an electret device according to a modification of the embodiment of the present invention, Fig. 3(b) is an exploded perspective view of the electret device in Fig. 3(a), and Fig. 3(c) is a back view of a lid member 20 in Fig. 3(a);
[Fig. 4] Fig. 4 is a cross-sectional view of the electret device in Fig. 3(a);
[Fig. 5] Figs. 5(a) to 5(c) are examples of attachment of a hydrogen getter according to modifications of the embodiment of the present invention;
[Fig. 6] Fig. 6(a) is a cross-sectional view of an electret device to which the lid member in Fig. 5(a) is attached, Fig. 6(b) is a cross-sectional view of an electret device to which the lid member in Fig. 5(b) is attached, and Fig. 6(c) is a cross-sectional view of an electret device to which the lid member in Fig. 5(c) is attached; and
[Fig. 7] Fig. 7 is the results of a charge degradation test on an electret device according to an embodiment of the present invention and that in a comparative example. Description of Embodiments

Embodiments of the present invention will be described in detail below. However, the present invention is not limited to these.

### <Configuration of Electret Device>

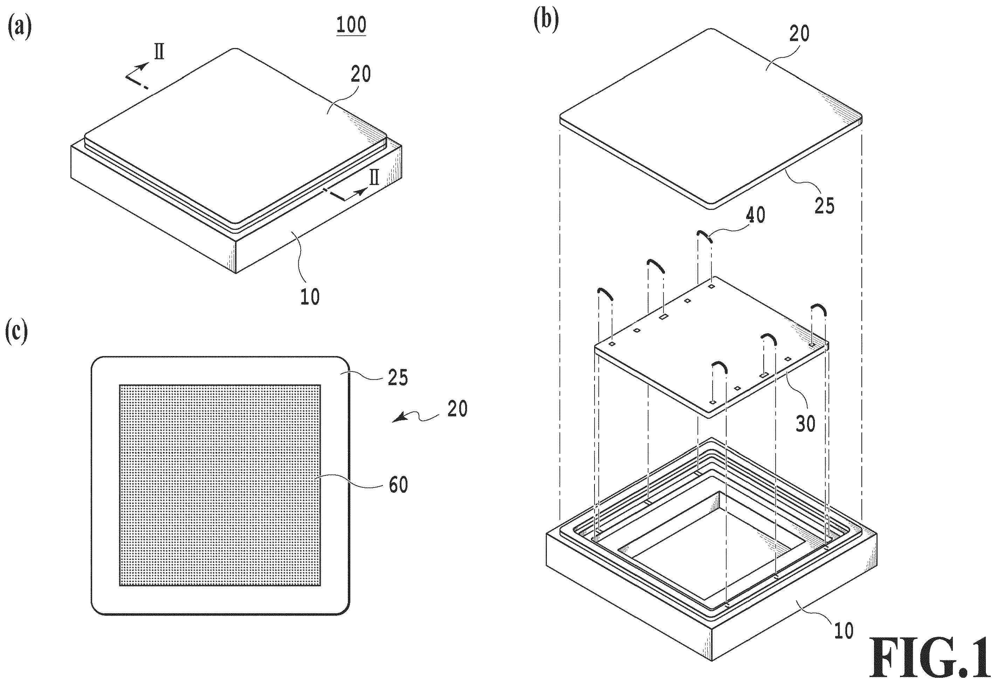

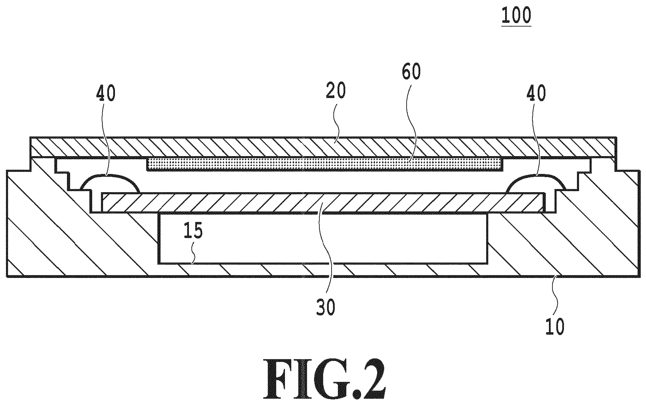

Fig. 1(a) is a perspective view generally illustrating an electret device according to an embodiment of the present invention, Fig. 1(b) is an exploded perspective view thereof, and Fig. 1(c) is a back view of a lid member. Also, Fig. 2 is a cross-sectional view of the electret device in Fig. 1(a).

In an embodiment of the present invention, an electret device 100 includes a package member 10, a lid member 20, an electret element 30, and a hydrogen getter 60. The package member 10 and the lid member 20 form a closed space, and the electret element 30 is placed in this closed space. Moreover, the electret element 30 is coupled to electrodes provided to the package member via wires 40 from electrode pads 31 and 32 provided to the element to be connected to an external circuit (not illustrated). The hydrogen getter 60 is placed in the closed space.

As will be described later in detail, in the present embodiment, the hydrogen getter 60 is provided on at least part of the package member 10 or the lid member 20 forming the closed space or of the electret element 30. In this way, it is possible to adsorb hydrogen in the closed space without performing a high-temperature activation treatment. Accordingly, it is possible to provide a long-life electret device preventing charge degradation of an electret element sealed in a closed space by hydrogen.

### (Package Member)

The package member 10 is a member in which the electret element 30 is placed and which forms a closed space together with the lid member 20 to be described later. The package member 10 has electrodes to be coupled to the electret element 30 via the wires 40, and can connect the electret element 30 to an external circuit.

As for the material used for the package member 10, a material generally used to seal an electronic element is usable. For example, ceramics, such as alumina, metals, resins, glass, and silicon are usable. Part of an inner wall 15 of the package member 10 may be processed to be water-repellent.

### (Lid Member)

The lid member 20 is a member forming the closed space together with the package member 10.

As for the material used for the lid member 20, a material generally used to seal an electronic element is usable. For example, the lid member 20 may be made of a metal, which is preferable since the lid member 20 can be sealed by welding. The metal used for the lid member 20 may be a single-component metal or an alloy. Part of an inner wall surface 25 of the lid member 20 may be processed to be water-repellent.

### (Electret Element)

The electret element 30 is an electronic element containing an electret and may be a vibration element that converts a vibrational energy into an electric energy, for example.

In this specification, a member obtained by, for example, applying a voltage to a heated oxide film will be referred to as an electret. Also, maintaining the charged state after the voltage application will be referred to as electretization. Moreover, an element using an electret will be referred to as an electret element. Furthermore, a device including an electret element will be referred to as an electret device.

An electret can be produced by a method known in the art. For example, an electret is made by performing the publicly known charging process disclosed in PTL 4. The electret element 30 may have a protection film on its electret surface.

The electret element 30 can be coupled to the package member 10 via the wires 40 to be connected to an external circuit (not illustrated).

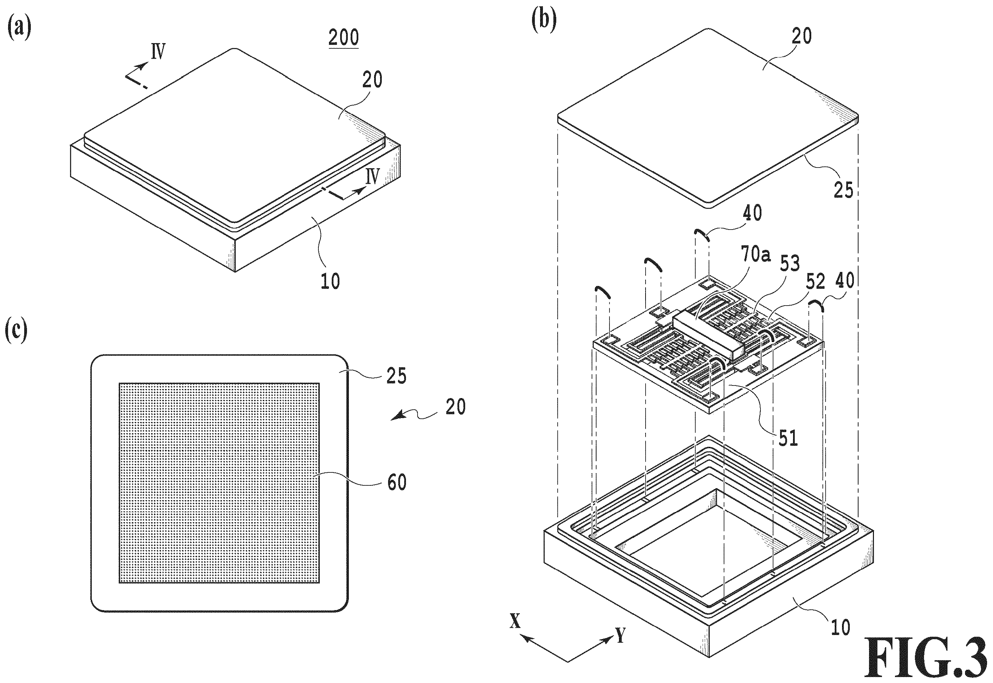

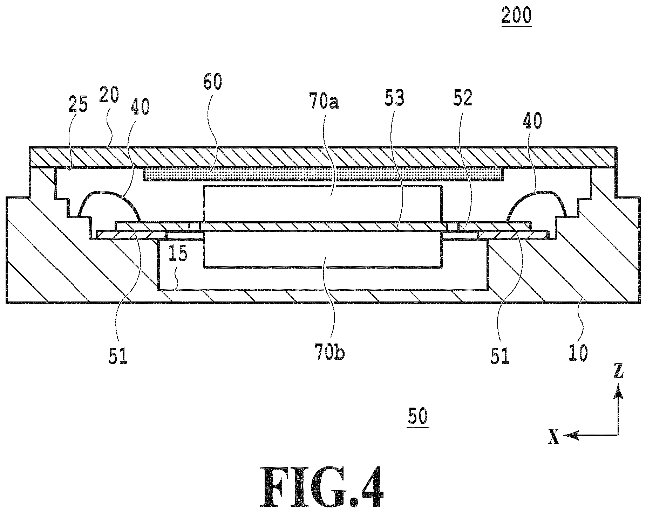

In a modification of the embodiment of the present invention, the electret element may be an electret element 50 having comb teeth-shaped electrode parts 52 and 53 (see Figs. 3(a) to 4). In the present embodiment, the electret element 50 has fixed comb teeth-shaped electrode parts 52 formed on a support part 51 and a movable comb teeth-shaped electrode part 53 elastically supported on the support part 51 with an elastic support part therebetween. The electret element 50 can be formed by a common MEMS processing technique using an SOI (Silicon On Insulator) substrate, for example. The SOI substrate is a three-layer substrate formed of a Si support layer, a SiO₂ box layer, and a Si active layer. The support part 51 is formed of the support layer, while the fixed comb teeth-shaped electrode parts 52, the movable comb teeth-shaped electrode part 53, and the elastic support part are formed of the active layer.

The comb teeth-shaped electrodes of the fixed comb teeth-shaped electrode parts 52 and the movable comb teeth-shaped electrode part 53 are disposed so as to mesh with each other with gaps therebetween in the y-axis direction. In a case where the movable comb teeth-shaped electrode part 53 vibrates in the x-axis direction, the amount by which the comb teeth-shaped electrodes of the movable comb teeth-shaped electrode part 53 are inserted in the comb teeth-shaped electrodes of the fixed comb teeth-shaped electrode parts 52 changes. This enables power generation. A pair of weights 70a and 70b may be fixedly attached to the front and back surfaces of a portion of the movable comb teeth-shaped electrode part 53 in order to make the vibration large and thereby improve the efficiency of power generation.

The fixed comb teeth-shaped electrode parts 52 are connected to the package member 10 via the wires 40, and is capable of sending electricity obtained by the vibration of the movable comb teeth-shaped electrode part 53 to an external circuit (not illustrated).

The electret element 50 contains an electret in at least part of either the comb teeth-shaped electrode parts 52 or the comb teeth-shaped electrode part 53. Also, the electret element 50 may have a protection film on its electret surface.

In the following, a description will be given using the electret element 30, but the description similarly applies to the case of using the electret element 50 as the electret element.

### (Closed Space)

In an embodiment of the present invention, as illustrated in Fig. 2, the package member 10 including the electret element 30 therein is sealed with the lid member 20 to form a closed space. The sealing can be performed in the atmospheric air, in the presence of an inert gas, such as nitrogen or argon, or under vacuum.

The sealing of the package member 10 and the lid member 20 can be performed using a common method. For example, it can be performed by welding the lid member 20.

### (Hydrogen Getter)

The hydrogen getter 60 is a substance that mainly adsorbs hydrogen, and adsorbs hydrogen in the closed space formed by the package member 10 and the lid member 20. As the hydrogen getter 60, a substance known as a hydrogen adsorbing substance in the art is usable. For example, the hydrogen getter disclosed in PTL 5 is usable.

As disclosed in PTL 5, even at relatively low temperatures, the hydrogen getter forms an initial solid solution as hydrogen atoms spread within the material, and can produce a hydride such as ZrH₂ as the hydrogen concentration rises. Thus, the hydrogen adsorption ability is high even at low temperatures. Accordingly, the hydrogen getter 60 can adsorb hydrogen in the closed space without being subjected to a high-temperature activation treatment. This makes it possible to avoid degradation of the electret by heating and thus prevent charge degradation of the electret by hydrogen.

The hydrogen getter 60 can be placed at any position in the closed space formed by the package member 10 and the lid member 20 as long as the hydrogen getter 60 does not impair the operation of the electret device 100. For example, as illustrated in Fig. 3(c), the hydrogen getter 60 may be placed so as to cover the inner wall surface 25 of the lid member 20 except for the edge portion that contacts the package member 10.

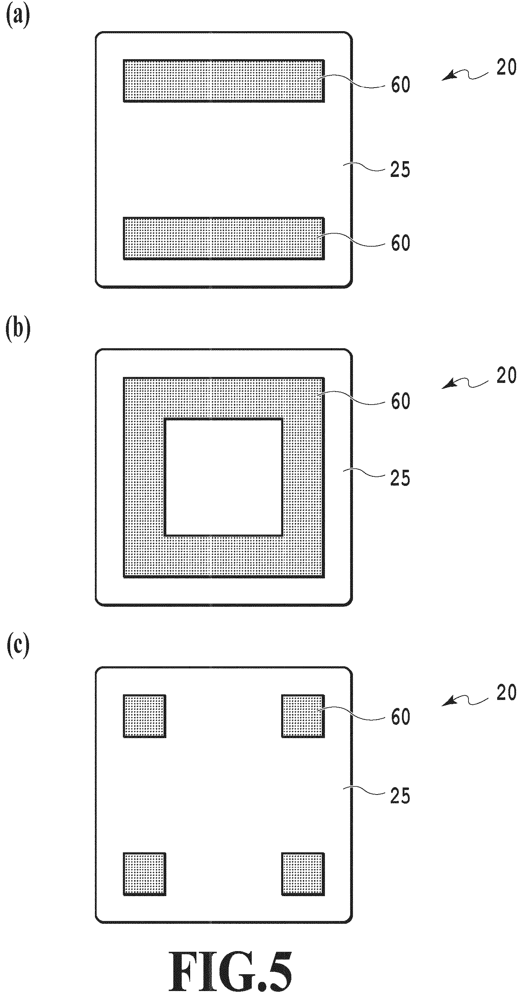

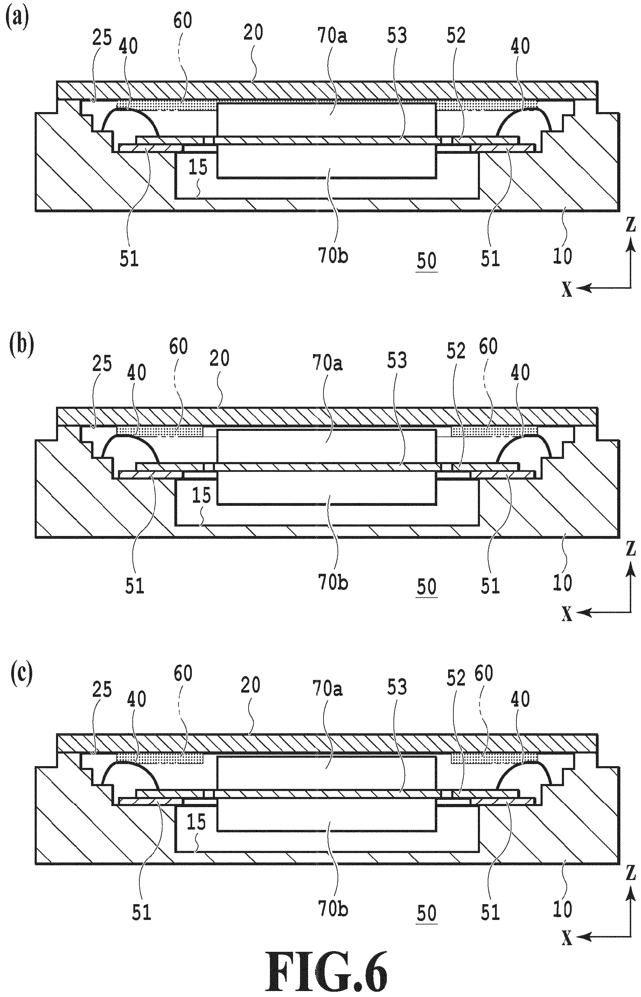

Moreover, as illustrated in Figs. 5(a) to 5(c), the hydrogen getter 60 may be provided on the inner wall surface 25 of the lid member 20 in such a shape as to avoid the portion facing the weight 70a placed on the movable comb teeth-shaped electrode part 53. Such a configuration can shorten the distance between the lid member 20 and the electret element 50 without obstructing the movement of the movable comb teeth-shaped electrode part 53 and therefore reduce the size of the electret device 100 (Figs. 6(a) to 6(c)). Also, in Figs. 6(a) to 6(c), the hydrogen getter 60 may extend in the Z-axis direction from the inner wall surface 25 of the lid member 20 toward the electret element 50 so as to fill a space around the weight 70a without obstructing the movement of the movable comb teeth-shaped electrode part 53. The hydrogen getter 60 has a thickness in a range smaller than the distance from the lid member 20 to the surfaces of the fixed comb teeth-shaped electrode parts 52. Such a configuration increases the surface area of the hydrogen getter 60, which can improve the adsorption ability of the hydrogen getter and is therefore expected to lengthen the life of the electret.

The above embodiment has been described based on a configuration in which the hydrogen getter 60 is attached to the lid member 20. Alternatively, the hydrogen getter 60 may be attached to the package member 10 or the electret element 30. Also, the hydrogen getter 60 may be attached to at least part of the package member 10, the lid member 20, or the electret element 30. The hydrogen getter 60 has a thickness in a range smaller than the distance between the package member 10 and the electret element 30 or a thickness in a range smaller than the distance between the lid member 20 and the electret element 30. Such a configuration can further increase the surface area of the hydrogen getter 60 without obstructing the movement of the movable comb teeth-shaped electrode part 53. The hydrogen getter 60 can be attached by, for example, a welding technique such as resistance welding, bonding using an adhesive, or the like.

### <Method of Manufacturing Electret Device>

Next, a method of manufacturing the electret device 100 in an embodiment of the present invention will be described.

The package member 10 and the lid member 20 are prepared, and the hydrogen getter 60 is placed on at least part of the inner wall 15 of the package member 10 or the inner wall surface 25 of the lid member 20. Then, the electret element 30 is placed in the package member 10, and the package member 10 is sealed with the lid member 20.

Incidentally, the sealing of the package member 10 with the lid member 20 can be performed in the atmospheric air, in the presence of an inert gas, such as nitrogen or argon, or under vacuum.

### <Performance Test of Electret Devices>

### (Example 1)

An electret element having a comb teeth-shaped chip was placed in a package member made of a ceramic, and the electrode chip was connected with wires. Then, a lid member made of Kovar with a hydrogen getter placed on the inner wall surface of the lid member was welded under vacuum to the package member with the electret element placed therein to thereby create a sealed electret device.

### (Comparative Example 1)

A sealed electret device was created in a similar manner to Example 1 except that no hydrogen getter was placed on the lid member.

### (Charge Retention Test)

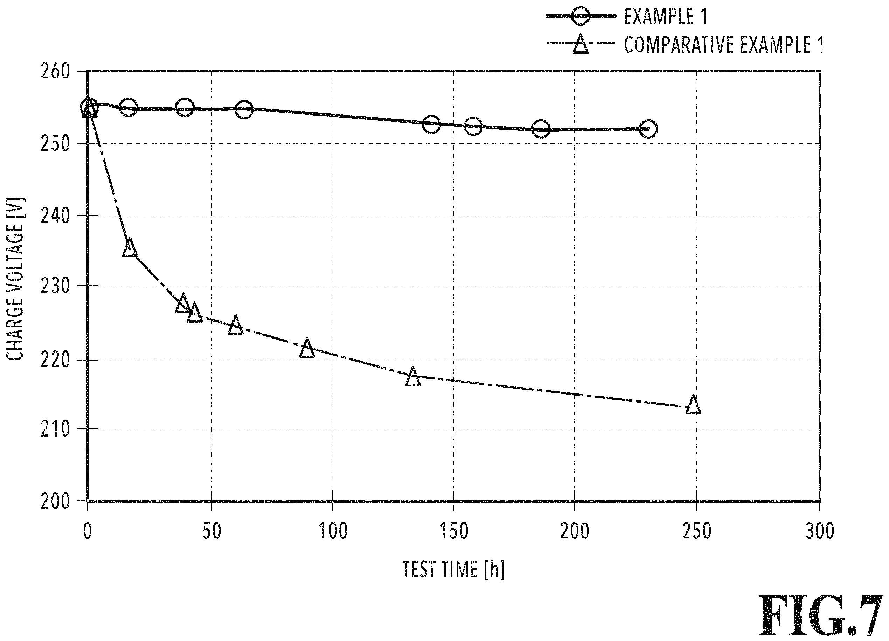

The electret devices created in Example 1 and Comparative Example 1 were heated to 100°C, and their charge voltages were measured. Fig. 7 illustrates the results.

As can been seen from Fig. 7, an abrupt decrease in charge voltage was observed in the electret device in Comparative Example 1, in which no hydrogen getter was placed, whereas no significant decrease in charge voltage was observed in the electret device in Example 1 even after 250 hours.

The embodiment described above brings about the following advantageous effects.
(1) The electret device includes a package member, a lid member, and an electret element, the lid member seals the package member to thereby form a closed space, the electret element is placed in the closed space, and a hydrogen getter is included in at least part of the inside of the closed space.
   With this configuration, the electret device can adsorb hydrogen in the closed space without being subjected to a high-temperature activation treatment. Accordingly, it is possible to provide a long-life electret device preventing charge degradation of an electret element sealed in a closed space by hydrogen.
(2) In the electret device, the hydrogen getter is placed on at least part of the package member.
   In this configuration, the hydrogen getter can be placed without greatly affecting the space inside the electret device.
(3) In the electret device, the hydrogen getter is placed on at least part of the lid member.
   In this configuration, the hydrogen getter can be placed without greatly affecting the space inside the electret device.
(4) In the electret device, the hydrogen getter is placed on at least part of the electret element.
   In this configuration, the hydrogen getter can be placed without greatly affecting the space inside the electret device.
(5) The electret element has a movable weight, and the hydrogen getter is placed at a region other than a portion facing the region where the weight is movable.
   With this configuration, the distance between the lid member 20 and the electret element 50 can be shortened without obstructing the movement of the movable comb teeth-shaped electrode part 53, and the size of the electret device 100 can therefore be reduced. The distance between the lid member and the electret element can be shortened without obstructing the movement of the movable part of the electret element, and the size of the electret device can therefore be reduced.
(6) In the electret device, the hydrogen getter has a thickness in a range smaller than the distance between the package member and the electret element.
   With this configuration, in the electret device, the surface area of the hydrogen getter 60 is increased so as to fill a space around the weight 70a without obstructing the movement of the movable comb teeth-shaped electrode part 53. This can improve the adsorption ability of the hydrogen getter and is therefore expected to lengthen the life of the electret.
(7) In the electret device, the hydrogen getter has a thickness in a range smaller than the distance between the lid member and the electret element.
   With this configuration, in the electret device, the surface area of the hydrogen getter 60 is increased so as to fill a space around the weight 70a without obstructing the movement of the movable comb teeth-shaped electrode part 53. This can improve the adsorption ability of the hydrogen getter and is therefore expected to lengthen the life of the electret.
(8) In the electret device, the package member is made of a material selected from among a ceramic, a metal, a resin, glass, and silicon.
   With this composition, the electret device can be sufficiently sealed in a simple manner and also suppress degradation of the electret.
(9) A method of manufacturing the electret device including a package member, a lid member, and an electret element includes: a step of preparing the package member; a step of placing the electret element in the package member; and a step of sealing the package member with the lid member to thereby form a closed space, the method including a step of providing a hydrogen getter on at least part of the package member or the lid member forming an inner wall of the closed space or the electret element before the sealing step.
   With this configuration, the electret device can adsorb hydrogen in the closed space without being subjected to a high-temperature activation treatment. Accordingly, it is possible to provide a long-life electret device preventing charge degradation of an electret element sealed in a closed space by hydrogen.
(10) In the method of manufacturing an electret device, the sealing is performed under vacuum.
   In this manner, water and the like is kept from entering the closed space from outside in the sealing step. This makes it possible to prevent degradation of the electret and suppress the resulting decrease in the output of the electret device.
(11) In the method of manufacturing an electret device, the sealing is performed in the presence of an inert gas.

In this manner, water and the like is kept from entering the closed space from outside in the sealing step. This makes it possible to prevent degradation of the electret and suppress the resulting decrease in the output of the electret device.

### Reference Signs List

- 10: package member
- 15: inner wall
- 20: lid member
- 25: inner wall surface
- 30: electret element
- 40: wire
- 50: electret element with comb teeth-shaped electrodes
- 51: support part
- 52: fixed comb teeth-shaped electrode part
- 53: movable comb teeth-shaped electrode part
- 60: hydrogen getter
- 70a: weight
- 70b: weight

## Claims

1. An electret device (100) comprising:
a package member (10);
a lid member (20); and
an electret element (30), wherein
the lid member (20) seals the package member (10) to thereby form a closed space,
the electret element (30) is placed in the closed space, and
**characterised in that**
a hydrogen getter (60) is included in at least part of an inside of the closed space.

2. The electret device (100) according to claim 1, wherein the hydrogen getter (60) is placed on at least part of the package member (10).

3. The electret device (100) according to claim 1, wherein the hydrogen getter (60) is placed on at least part of the lid member (20).

4. The electret device (100) according to claim 1, wherein the hydrogen getter (60) is placed on at least part of the electret element (30).

5. The electret device (100) according to any one of claims 2 to 4, wherein
the electret element (30) has a movable weight (70a, 70b), and
the hydrogen getter (60) is placed at a region other than a portion facing a region where the weight is movable (70a, 70b).

6. The electret device (100) according to claim 5, wherein the hydrogen getter (60) has a thickness in a range smaller than a distance between the package member (10) and the electret element (30).

7. The electret device (100) according to claim 5, wherein the hydrogen getter (60) has a thickness in a range smaller than a distance between the lid member (20) and the electret element (30).

8. The electret device (100) according to any one of claims 1 to 7, wherein the package member (10) is made of a material selected from among a ceramic, a metal, a resin, glass, and silicon.

9. A method of manufacturing an electret device (100) including a package member (10), a lid member (20), and an electret element (30), the method comprising:
a step of preparing the package member (10);
a step of placing the electret element (30) in the package member (10); and
a step of sealing the package member (10) with the lid member (20) to thereby form a closed space, and
**characterised in that**
the method comprises a step of providing a hydrogen getter (60) on at least part of the package member (10) or the lid member (20) forming an inner wall of the closed space or the electret element (30) before the sealing step.

10. The method according to claim 9, wherein the hydrogen getter (60) is placed on at least part of the package member (10).

11. The method according to claim 9, wherein the hydrogen getter (60) is placed on at least part of the lid member (20).

12. The method according to claim 9, wherein the hydrogen getter (60) is placed on at least part of the electret element (30).

13. The method according to any one of claims 9 to 12, wherein the sealing is performed under vacuum.

14. The method according to any one of claims 9 to 12, wherein the sealing is performed in a presence of an inert gas.

15. The method according to any one of claims 9 to 14, wherein the package member (10) is made of a material selected from among a ceramic, a metal, a resin, glass, and silicon.

## Patentansprüche

1. Elektretvorrichtung (100) mit:
einem Gehäuseteil (10);
einem Deckelteil (20); und
einem Elektretelement (30), bei der
das Deckelteil (20) das Gehäuseteil (10) abdichtet zum Bilden eines geschlossenen Zwischenraums,
das Elektretelement (30) in dem geschlossenen Zwischenraum platziert ist, und **dadurch gekennzeichnet, dass**
ein Wasserstoffgetter (60) in mindestens einem Teil eines Inneren des geschlossenen Zwischenraums aufgenommen ist.

2. Elektretvorrichtung (100) nach Anspruch 1, bei der der Wasserstoffgetter (60) auf mindestens einem Teil des Gehäuseteils (10) platziert ist.

3. Elektretvorrichtung (100) nach Anspruch 1, bei der der Wasserstoffgetter (60) auf mindestens einem Teil des Deckelteils (20) platziert ist.

4. Elektretvorrichtung (100) nach Anspruch 1, bei der der Wasserstoffgetter (60) auf mindestens einem Teil des Elektretelements (30) platziert ist.

5. Elektretvorrichtung (100) nach einem der Ansprüche 2 bis 4, bei der
das Elektretelement (30) ein bewegbares Gewicht (70a, 70b) aufweist, und
der Wasserstoffgetter (60) in einer anderen Region platziert ist als ein Abschnitt, der einer Region gegenüberliegt, in der das Gewicht (70a, 70b) bewegbar ist.

6. Elektretvorrichtung (100) nach Anspruch 5, bei der der Wasserstoffgetter (60) eine Dicke in einem Bereich aufweist, der kleiner ist als ein Abstand zwischen dem Gehäuseteil (10) und dem Elektretelement (30).

7. Elekretvorrichtung (100) nach Anspruch 5, bei der der Wasserstoffgetter (60) eine Dicke in einem Bereich aufweist, der kleiner ist als ein Abstand zwischen dem Deckelteil (20) und dem Elektretelement (30).

8. Elektretvorrichtung (100) nach einem der Ansprüche 1 bis 7, bei der das Gehäuseteil (10) aus einem Material hergestellt ist, das aus einer Keramik, einem Metall, einem Harz, Glas und Silizium ausgewählt ist.

9. Verfahren zum Herstellen einer Elektretvorrichtung (100), die ein Gehäuseteil (10), ein Deckelteil (20) und ein Elektretelement (30) aufweist, welches Verfahren aufweist:
einen Schritt des Vorbereitens des Gehäuseteils (10);
einen Schritt des Platzierens des Elektretelements (30) in dem Gehäuseteil (10); und
einen Schritt des Abdichtens des Gehäuseteils (10) mit dem Deckelteil (20) zum Bilden eines geschlossenen Zwischenraums, und
**dadurch gekennzeichnet, dass**
das Verfahren einen Schritt des Vorsehens eines Wasserstoffgetters (60) auf mindestens einem Teil des Gehäuseteils (10) oder des Deckelteils (20), der eine Innenwand des geschlossenen Zwischenraums ausbildet, oder des Elektretelements (30) vor dem Abdichtungsschritt aufweist.

10. Verfahren nach Anspruch 9, bei dem der Wasserstoffgetter (60) auf mindestens einem Teil des Gehäuseteils (10) platziert wird.

11. Verfahren nach Anspruch 9, bei dem der Wasserstoffgetter (60) auf mindestens einem Teil des Deckelteils (20) platziert wird.

12. Verfahren nach Anspruch 9, bei dem der Wasserstoffgetter (60) auf mindestens einem Teil des Elektretelements (30) platziert wird.

13. Verfahren nach einem der Ansprüche 9 bis 12, bei dem das Abdichten unter Vakuum durchgeführt wird.

14. Verfahren nach einem der Ansprüche 9 bis 12, bei dem das Abdichten in Anwesenheit eines Inertgases durchgeführt wird.

15. Verfahren nach einem der Ansprüche 9 bis 14, bei dem das Gehäuseteil (10) aus einem Material hergestellt ist, das aus einer Keramik, einem Metall, einem Harz, Glas und Silizium ausgewählt ist.

## Revendications

1. Dispositif à électret (100) comprenant :
un élément de boîtier (10) ;
un élément de couvercle (20) ; et
un élément électret (30), dans lequel
l'élément de couvercle (20) scelle l'élément de boîtier (10) pour former ainsi un espace clos,
l'élément électret (30) est placé dans l'espace clos, et
**caractérisé en ce que**
un getter d'hydrogène (60) est inclus dans au moins une partie d'un intérieur de l'espace clos.

2. Le dispositif à électret (100) selon la revendication 1, dans lequel le getter d'hydrogène (60) est placé sur au moins une partie de l'élément de boîtier (10).

3. Le dispositif à électret (100) selon la revendication 1, dans lequel le getter d'hydrogène (60) est placé sur au moins une partie de l'élément de couvercle (20).

4. Le dispositif à électret (100) selon la revendication 1, dans lequel le getter d'hydrogène (60) est placé sur au moins une partie de l'élément électret (30).

5. Le dispositif à électret (100) selon l'une quelconque des revendications 2 à 4, dans lequel
l'élément électret (30) présente une masse mobile (70a, 70b), et
le getter d'hydrogène (60) est placé au niveau d'une région autre qu'une partie faisant face à une région où la masse est mobile (70a, 70b).

6. Le dispositif à électret (100) selon la revendication 5, dans lequel le getter d'hydrogène (60) présente une épaisseur dans une plage inférieure à une distance entre l'élément de boîtier (10) et l'élément électret (30).

7. Le dispositif à électret (100) selon la revendication 5, dans lequel le getter d'hydrogène (60) présente une épaisseur dans une plage inférieure à une distance entre l'élément de couvercle (20) et l'élément électret (30).

8. Le dispositif à électret (100) selon l'une quelconque des revendications 1 à 7, dans lequel l'élément de boîtier (10) est constitué d'un matériau choisi parmi une céramique, un métal, une résine, du verre et du silicium.

9. Procédé de fabrication d'un dispositif à électret (100) incluant un élément de boîtier (10), un élément de couvercle (20) et un élément électret (30), le procédé comprenant :
une étape de préparation de l'élément de boîtier (10) ;
une étape de mise en place de l'élément électret (30) dans l'élément de boîtier (10) ; et
une étape de scellement de l'élément de boîtier (10) avec l'élément de couvercle (20) pour former ainsi un espace clos, et
**caractérisé en ce que**
le procédé comprend une étape consistant à prévoir un getter d'hydrogène (60) sur au moins une partie de l'élément de boîtier (10) ou de l'élément de couvercle (20) formant une paroi intérieure de l'espace clos ou de l'élément électret (30) avant l'étape de scellement.

10. Le procédé selon la revendication 9, dans lequel le getter d'hydrogène (60) est placé sur au moins une partie de l'élément de boîtier (10).

11. Le procédé selon la revendication 9, dans lequel le getter d'hydrogène (60) est placé sur au moins une partie de l'élément de couvercle (20).

12. Le procédé selon la revendication 9, dans lequel le getter d'hydrogène (60) est placé sur au moins une partie de l'élément électret (30).

13. Le procédé selon l'une quelconque des revendications 9 à 12, dans lequel le scellement est effectué sous vide.

14. Le procédé selon l'une quelconque des revendications 9 à 12, dans lequel le scellement est effectué en présence d'un gaz inerte.

15. Le procédé selon l'une quelconque des revendications 9 à 14, dans lequel l'élément de boîtier (10) est constitué d'un matériau choisi parmi une céramique, un métal, une résine, du verre et du silicium.
